# EUROPEAN PATENT APPLICATION

(11) **EP 3 584 847 A1**
(43) Date of publication of application: **25.12.2019**
(21) Application number: 18178306.9
(22) Date of filing: 18.06.2018
(51) Int. Cl.: H01L 39/24, H01L 39/14

(54) **METHOD FOR FABRICATION OF A HTS COATED TAPE**

(71) Applicant: Bruker HTS GmbH, 63450 Hanau (DE)
(72) Inventor: Usoskin, Alexander, 63456 Hanau (DE); Betz, Ulrich, 63755 Alzenau (DE)
(74) Representative: Kohler Schmid Möbus Patentanwälte

(57) **Abstract**

A method for manufacturing an HTS coated tape (34),
the method comprising
- providing a substrate tape (1),
- depositing a textured buffer layer (3) onto a front side (7) of the substrate tape (1), and
- depositing an HTS layer (32) onto the front side (7) of the substrate tape (1), characterized by
the method further comprising
- depositing a functional layer (2) onto a bottom side (6) of the substrate tape (1), wherein the functional layer (2) exerts a mechanically deforming effect on the substrate tape (1) opposite to a mechanically deforming effect on the substrate tape (1) exerted by the textured buffer layer (3) deposited on the front (7) side of the substrate tape (1),
and wherein the depositing of the functional layer (2) is at least partially done before and/or during the depositing of the textured buffer layer (3). The invention proposes a method for producing a HTS coated tape, with which higher critical currents of the HTS layer may be achieved.

## Description

The invention relates to a method for manufacturing an HTS coated tape, the method comprising
- providing a substrate tape,
- depositing a textured buffer layer onto a front side of the substrate tape, and
- depositing an HTS layer onto the front side of the substrate tape.

Such method is known from EP 2 410 586 A1.

Superconductors can be used to carry an electric current at practically no ohmic losses, for example in order to produce high strength magnetic fields in superconducting magnet coils, or simply to transport the current from a source to a consumer. Superconductor materials have to be cooled to cryogenic temperatures in order to assure superconductivity. While low temperature superconductors (=LTS) such as NbTi are in general metallic and therefore can be prepared easily for example as drawn wires, high temperature superconductors (=HTS) such as YBCO are in general ceramic and therefore are often prepared as tape type superconductors to compensate for the brittle characteristics of the ceramic HTS.

A HTS coated tape typically comprises a substrate tape of flexible material such as steel, covered with a textured buffer layer, and a HTS layer. The textured buffer layer grows in a textured way on the substrate tape, i.e. there is a particular orientation of buffer layer crystals with respect to the substrate tape surface. The HTS layer deposited on top of the textured buffer layer also grows in a textured way, what results in a high critical current of the HTS layer. Note that a HTS coated tape may comprise further buffer layers, in addition to the textured buffer layer.

HTS coated tapes often show a bending across their width, even though the substrate tapes at which the manufacturing process started were flat. The bending is particularly pronounced for HTS coated tapes with thin substrate tapes and/or substrate tapes with a large width. This bending of the HTS coated tapes makes it difficult to wind coils from them, and the resulting conductor geometry in the wound coils limits the engineering current density and, as a result, the achievable magnetic field strength.

More severely, HTS coated tapes exhibiting said bending often show a relatively low critical current Ic, what limits practical applications.

From US 8,859,395 B2 techniques for curvature control in power transistor devices are known. In a method for preparing a DMOS device, a DMOS film is deposited on top of a substrate. After thinning the substrate from the bottom, the DMOS device shows significant bending. Then on top of the DMOS film, a thin film or stress compensation layer is deposited that counterbalances at least part of the residual stress of the DMOS device, and renders the DMOS device flat.

US 9,291,638 B2 describes some substrate curvature compensation methods and apparatus, for use with an accelerometer, using a compensation circuit.

### Object of the invention

It is the object of the invention to propose a method for producing a HTS coated tape, with which higher critical currents of the HTS layer may be achieved.

### Short description of the invention

This object is achieved, in accordance with the invention, by a method as introduced in the beginning, characterized by the method further comprising - depositing a functional layer onto a bottom side of the substrate tape, wherein the functional layer exerts a mechanically deforming effect on the substrate tape opposite to a mechanically deforming effect on the substrate tape exerted by the textured buffer layer deposited on the front side of the substrate tape, and wherein the depositing of the functional layer is at least partially done before and/or during the depositing of the textured buffer layer.

In the course of the inventive method, the textured buffer layer is deposited on the front side of the substrate tape. The textured buffer layer produces a deforming effect on the substrate tape, so without other measures, a significant strain of the substrate tape would result from the deposition of the buffer layer; the strain (deformation) typically is above all a bending of the substrate tape across its width, starting from a flat substrate tape; the strain (deformation) may also include a bending across its length, though. Increase of strain is a nonlinear process that accompanies the thickness increase of the textured buffer layer. The strain is growing mainly during particular phases of the formation of the texture of the buffer layer (at least for YSZ buffers).

According to the invention, a functional layer is deposited on the bottom side of the substrate tape. The functional layer produces a deforming effect opposite to the deforming effect of the textured buffer layer, so the functional layer may at least partially suppress the deforming effect caused by the buffer layer. In general, the overall strain of the final HTS coated tape using the functional layer will be smaller as compared to a HTS coated conductor tape not using a functional layer. This can be beneficial when winding coils from the HTS coated tape, in particular the wound coils may achieve higher field strengths.

As an important aspect of the inventive method, the deposition of the functional layer is done at least partially before or during the deposition of the textured buffer layer, thus limiting or preventing a mechanical strain of the substrate tape *already when the textured buffer layer is deposited.* The invention allows a "quasi-continuous removal" of mechanical strain, before it can manifest. The substrate tape can be kept basically flat over the entire manufacturing process, and in particular during deposition of the textured buffer layer. Surprisingly, this has been found to lead to a significant improvement of the critical current density achievable in the HTS coated tape.

Although not fully understood, the inventors assume that the inventive method leads to a growth of the textured buffer layer with a highly homogenous texture, even near the side edges of the substrate tape where a bending would lead to significant inclination of the substrate tape surface which could deteriorate texture homogeneity in typical buffer layer deposition processes. Then a highly homogeneous texture of the HTS layer may be achieved across the entire tape width with high critical current density, which in turn results in a high overall critical current of the HTS layer.

A further important feature is that the functional layer is deposited on the bottom side of the substrate tape. Only then it is possible to deposit the functional layer before or during the deposition of the textured buffer layer, and at the same time not to affect the formation of the substrate tape / textured buffer layer / HTS layer system on the front side.

In a simple variant, starting from a flat substrate, some functional layer material can be deposited first, causing some "negative" deformation of the substrate. A subsequent deposition of buffer layer material will initially reduce the "negative" deformation until the substrate is flat again, and further deposition of buffer layer material will accumulate some "positive" deformation. As compared to deposition of the complete textured buffer layer starting from a flat substrate without depositing some functional layer before, the maximum absolute strain (as compared to the flat substrate) of the substrate tape during the buffer layer deposition will be reduced. For example when the absolute values of the "negative" and "positive" deformation are equal in the variant, the absolute maximum strain occurring during deposition of the textured buffer layer will be halved.

In a more elaborate variant, the functional layer material is deposited at least partially during deposition of the textured buffer layer. Typically in this variant, textured buffer layer and functional layer are deposited stepwise and alternatingly. For example, when depositing the buffer layer in N equal steps and depositing the functional layer also in N equal steps, wherein alternating steps of functional layer deposition and buffer layer deposition pairwise eliminate exactly their mutual deformation, the maximum absolute strain during deposition is not more than 1/N times the strain that would result from a deposition of the complete buffer layer starting from a flat substrate without depositing any functional layer.

Note that a deposition of the functional layer during the deposition of the textured buffer layer, in accordance with the invention, does not require a concurrent deposition of functional layer material and buffer layer material; the criterion in accordance with the invention requires only that (at least some) functional layer material is deposited after deposition of the (entire) textured buffer layer has started and before deposition of the (entire) textured buffer layer has ended.

The textured buffer layer is typically an in-plane textured buffer layer. Note that the textured buffer layer may comprise a plurality of different sub-layers, in particular of different materials such as YSZ and CeO₂. The manufacturing of the HTS coated tape typically also includes polishing the substrate tape (at least on the front side), further typically includes depositing a cap buffer layer onto the front side of the substrate tape before and/or after deposition of the textured buffer layer, and typically also includes a deposition of a metallic envelope (at least) on the front side of the substrate tape. A deforming effect of the front side layers is typically generated above all by the textured buffer layer.

The HTS material is typically YBCO. The substrate tape is typically made of a flexible metal, such as stainless steel or Hastelloy. A typical substrate tape thickness is 100 µm or less, such as about 50 µm, in particular between 40 µm and 200 µm. A typical thickness of the functional layer is between 0.1 µm and 3 µm. A typical thickness of the textured buffer layer is between 0.1 µm and 3 µm. A typical HTS layer thickness is between 0.5 µm and 3 µm.

### Preferred embodiments of the invention

In a preferred variant of the inventive method, at least a part of the functional layer is deposited onto the bottom side of the substrate tape before the textured buffer layer is deposited onto the front side of the substrate tape. By this means, a preparatory "negative" deformation of an initially typically flat substrate tape can be established by the functional layer material, so the following deposition of buffer layer material will first reduce this "negative" deformation, typically until the substrate tape is flat again, and only after that "positive" deformation by effect of the buffer layer material will be built up; however this "positive" deformation will be lower as compared to the situation with the same amount of buffer layer material if no preparatory functional layer material and negative deformation had been applied. Preferably, if the buffer layer is deposited in only one step, one half of the functional layer is deposited before deposition of the textured buffer layer, and one half of the buffer layer is deposited after the deposition of the buffer layer.

A particularly preferred variant provides that depositing the textured buffer layer includes several buffer layer deposition steps and depositing the functional layer includes several functional layer deposition steps, and that the buffer layer deposition steps and functional layer deposition steps are done alternatingly. This is a simple way to deposit the functional layer at least partially during the deposition of the textured buffer layer. Each deposition step causes only a small amount of deformation of the substrate tape that is not enough to deteriorate the buffer layer texture quality, and by alternating the deposition steps of the buffer layer material and the functional layer material, such small amounts of deformation can be promptly removed again. Note that by increasing the number of deposition steps, the maximum strain (deformation) of the substrate tape in the course of the manufacturing of the HTS coated tape may be decreased. Preferably, there are at least 3 buffer layer deposition steps, and preferably there are at least 3 functional layer deposition steps.

In an advantageous variant, depositing the textured buffer layer and the functional layer includes concurrent deposition of buffer layer material on the front side and deposition of functional layer material on the bottom side at the same longitudinal position of the substrate tape. By this means, using matched deposition speeds for both materials, a strain (deformation) of the substrate tape can be completely avoided during deposition of the textured buffer layer. Newly deposited buffer layer material on the front side of the substrate comes along with newly deposited functional layer material on the back side of the substrate, cancelling out each other's deforming effect without any forerun or delay. Although requiring some apparatus efforts, this variant allows for the best quality of HTS coated tapes.

Further preferred is a variant wherein the deposition of the textured buffer layer is done with IBAD or ABAD or ISD. The texture of IBAD (Ion beam assisted deposition) and ABAD (Alternating beam assisted deposition) and ISD (inclined substrate deposition) deposited textured buffer layers is particularly sensitive to strain (tape bending), so the invention is particularly useful in these cases. However note that other deposition techniques may also profit from the invention, in particular if the deposition involves some kind of predominant direction of deposition from a source to the substrate tape. A typical substrate tape temperature for IBAD or ABAD is 100°-150°C. Note that the HTS layer is typically deposited by PLD, typically at a substrate temperature of 700°C-800°C.

In a preferred variant, the deposition of the functional layer is done by sputtering. This is simple and inexpensive to do. Note that in accordance with the invention, the same deposition methods and/or the same deposition materials can be used for depositing the textured buffer layer and the functional layer.

In another preferred variant, the functional layer comprises an oxide material, in particular YSZ and/or GdZrO and/or MgO. These materials allow a strong deforming effect on typical substrate tape materials such as stainless steel or Hastelloy tapes.

Particularly preferred is a variant wherein the material of the textured buffer layer and the material of the functional layer are similar or identical. The materials are considered similar if their elemental compositions are identical for at least 95 mass%, preferably for at least 99 mass%. This protects against "inter-poisoning" of the textured buffer layer and functional layer, and higher critical currents (Ic) of the final HTS coated tape may be achieved.

Further preferred is a variant wherein the method is applied to a substrate tape having a width of at least 3 mm, preferably at least 8 mm, most preferably at least 12 mm, and/or a substrate tape having an aspect ratio A=W/T, wherein A≥40, preferably A≥80, most preferably A≥200, with W: width of substrate tape and T: thickness of substrate tape. For substrate tapes with a large width and with large aspect ratios, bending of substrate tape due to a deforming effect caused by the textured buffer layer can be particularly severe; then the invention is particularly beneficial. These substrate tapes can be made suitable or improved for applications by means of the invention, in particular by achieving a higher critical current density of a deposited HTS layer near their side edges.

A particularly preferred variant provides that a degree of substrate tape strain, in particular a substrate tape curvature with respect to a width direction, is repeatedly or continuously monitored during manufacturing of the HTS coated tape, and used to feedback-control the deposition of the textured buffer layer and/or the deposition of the functional layer. In this way, high critical currents of the HTS coated tape can be achieved very reliably. The feedback-control is used to limit the substrate tape strain to an acceptable degree during manufacturing at least of the textured buffer layer, such that a degree of texture and its homogeneity of the textured buffer layer is kept high, and/or such that cracks caused by deforming are prevented. Typically, the feedback control makes sure that the strain does not exceed a programmed critical limit value.

In an advantageous variant, the manufacturing of the HTS coated tape is done such that a substrate tape curvature with respect to a width direction is limited such that a maximum mutual inclination of surface areas does not exceed 4°, preferably 2°, at any time during deposition of the textured buffer layer. Such a limitation of mutual inclination can be achieved by means of the invention. A maximum of 4°, or even 2°, mutual inclination (angle between the tangents at the substrate tape surface areas which are bent the most to each other, typically at the side edges of the substrate tape in a plane perpendicular to the longitudinal direction) is typically enough to ensure a good texture quality of the textured buffer layer. The substrate may remain in a desired orientation with respect to a predominant material deposition / ion flow direction basically over its entire width.

A preferred variant provides that the functional layer is deposited before deposition of a cap buffer layer or before deposition of the HTS layer. In order to improve the texture quality of the textured buffer layer, deposition of the functional layer should be completed before a cap buffer layer or HTS layer are deposited. Moreover, depositing functional layer material after the cap buffer layer or the HTS layer have been deposited may cause a poisoning of the atomically clean surface which is ready for HTS deposition; after HTS deposition, the "poisoning" may result in formation of an insulation (dielectric) layer on the top of HTS layer, thus HTS conductor may lose main functionality because said insulation layer may act as a barrier for the injection of transport current.

Advantageous is a variant providing that during deposition of the textured buffer layer and deposition of the functional layer, the substrate tape is translated between two reservoirs at least once, and preferably translated forth and back several times, and that upon being translated between the two reservoirs, the substrate tape passes through at least one deposition zone for depositing buffer layer material and/or functional layer material on the substrate tape. This is a simple method for depositing buffer layer material and functional layer material on the substrate tape. Note that if the buffer layer material and the functional layer material are identical, one deposition zone is sufficient for growing both the textured buffer layer and the functional layer; note that the substrate tape has to be twisted to switch the substrate side facing the material source. Each time the substrate tape passes through a deposition zone (e.g. upon every translation between the reservoirs), some material is deposited on the substrate side facing the material source, so multiple passing of a deposition zone or zones may be used for stepwise deposition of material.

In a preferred further development of this variant, the translation between the two reservoirs is done using a multipath translation area with a multitude of windings of the substrate tape, wherein the substrate tape is twisted at least once by a half turn within the multipath translation area. A multipath area at a deposition zone allows material deposition on the substrate tape with multiple deposition steps per one translation between the reservoirs. A half turn twist within the multipath translation area (i.e. between two windings of the multipath translation area) allows a change of the substrate side (front/back) on which material is deposited within one deposition zone, so often the manufacturing of the HTS coated tape can be done with one deposition zone only. However note that it is also possible to use several deposition zones, for example one deposition zone per substrate side.

In a preferred variant, the deposition of the layers on the front side and on the bottom side of the substrate tape, in particular the deposition of the textured buffer layer and the deposition of the functional layer, are done such that their deforming effects are in total cancelled out, so the resulting HTS coated tape is without strain. If the resulting HTS coated tape is without strain (undeformed, in particular not bent), winding of the HTS coated tape into a coil is facilitated and can be done with no or only few empty spaces. As a result, a high effective engineering current density (i.e. current per unit area of spool/winding cross-section including empty spaces) may be achieved, and the resulting coil may enable therefore a high magnetic field strength. Note that the balanced deforming effects of the front side and the bottom side layers of a HTS coated tape can be considered as a separate invention, independent of the sequence of deposition of function layer and textured buffer layer as stated in claim 1.

Also within the scope of the present invention is a HTS coated tape, manufactured according to an inventive method as described above. The HTS coated tape manufactured in this way may achieve a high critical current, and is well suitable for applications such as superconducting cables for current transport (power lines) or for manufacturing magnet coils/spools or motor/generator coils, for transformer or for current limiters.

Further advantages can be extracted from the description and the enclosed drawing. The features mentioned above and below can be used in accordance with the invention either individually or collectively in any combination. The embodiments mentioned are not to be understood as exhaustive enumeration but rather have exemplary character for the description of the invention.

### Drawing

The invention is shown in the drawing.

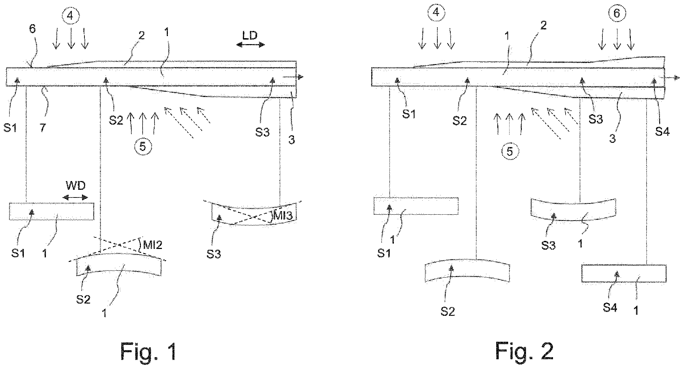

- Fig. 1: shows a schematic side view and strain status of a substrate tape being coated with functional layer material and buffer layer material during a translation process in accordance with the invention, wherein the functional layer is deposited before the textured buffer layer is deposited;
- Fig. 2: shows a schematic side view and strain status of a substrate tape being coated with functional layer material and buffer layer material during a translation process in accordance with the invention, wherein the a part of the functional layer is deposited before the textured buffer layer is deposited, and a part of the functional layer is deposited after the textured buffer layer is deposited;

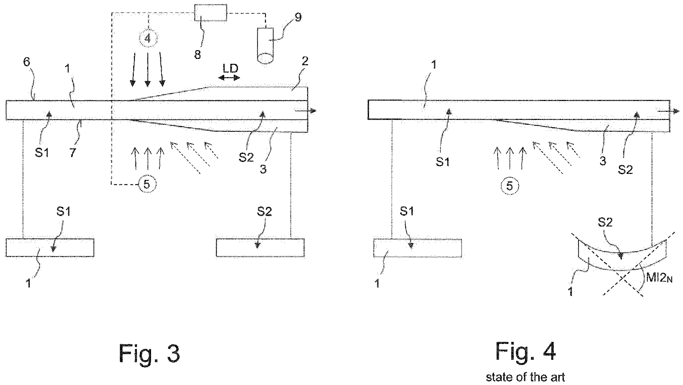

- Fig. 3: shows a schematic side view and strain status of a substrate tape being coated with functional layer material and buffer layer material during a translation process in accordance with the invention, wherein the functional layer is deposited concurrently with the textured buffer layer at the same longitudinal position;
- Fig. 4: shows a schematic side view and strain status of a substrate tape being coated with buffer layer material during a translation process according to the state of the art;

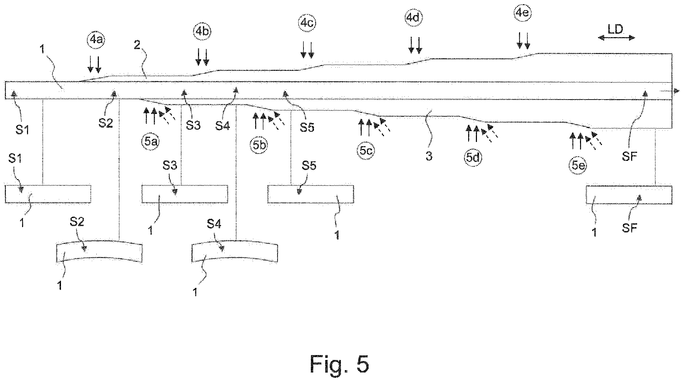

- Fig. 5: shows a schematic side view and strain status of a substrate tape being coated with functional layer material and buffer layer material during a translation process in accordance with the invention, wherein deposition of functional layer material and buffer layer material is done in alternating steps;

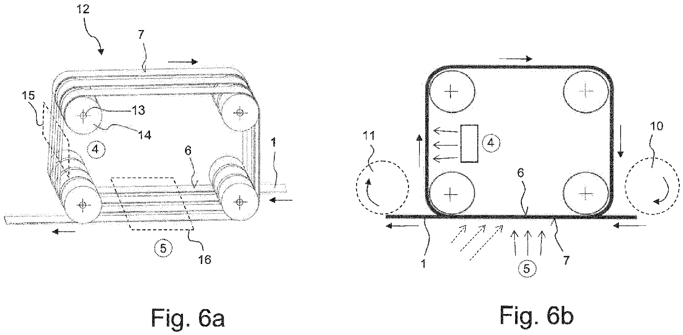

- Fig. 6a: shows a schematic perspective view of a winding rack for a substrate tape being coated with buffer layer material in a first deposition zone and functional layer material in a second deposition zone, wherein in each deposition zone multiple windings of the substrate tape run in parallel, in accordance with the invention;
- Fig. 6b: shows a schematic side view of the winding rack of Fig. 6b;

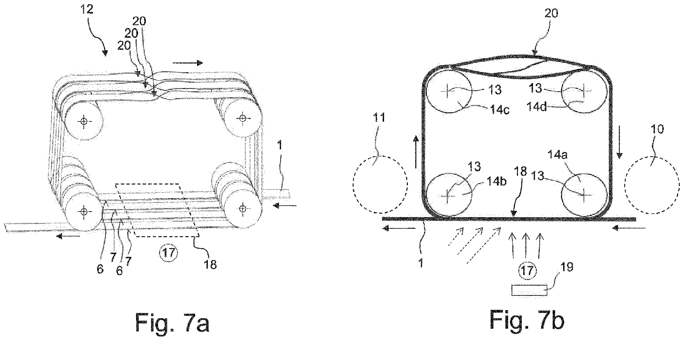

- Fig. 7a: shows a schematic perspective view of a winding rack for a substrate tape being coated with buffer layer material and functional layer material in a common deposition zone, wherein the substrate type is twisted between some of the windings of the substrate tape running in parallel in the deposition zone, in accordance with the invention;
- Fig. 7b: shows a schematic side view of the winding rack of Fig. 7b;

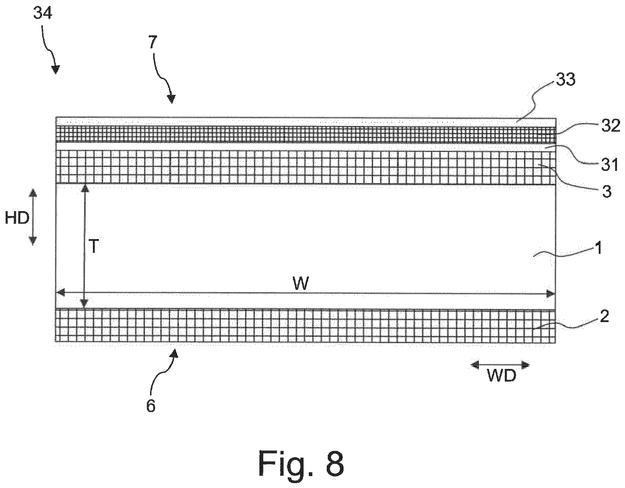

- Fig. 8: shows a cross-section of a HTS coated tape perpendicular to the longitudinal direction, produced in accordance with the invention.

It should be noted that the figures are schematic in nature, and some features may be shown in an exaggerated or understated way, in particular thicknesses of functional layer and textured buffer layer, in order to show particular features of an inventive HTS conductor tape or an inventive production method more clearly.

**Fig. 1** illustrates a first variant of an inventive method for producing an HTS coated tape, when a functional layer 2 and a textured buffer layer 3 are deposited on opposing sides of a substrate tape 1 (see upper part of Fig. 1).

Note that for simplicity, subsequent deposition of a HTS layer is not illustrated (but compare Fig. 8).

In the variant illustrated, the substrate tape 1 is translated in Fig. 1 from left to right, wherein the substrate tape 1 passes subsequently two deposition zones 4, 5. The substrate tape 1 is initially flat, compare state S1 (see lower part of Fig. 1 for a cross-section of the substrate tape 1 perpendicular to the longitudinal direction LD). In particular, the substrate tape 1 is not bent along its width direction WD.

At the deposition zone 4, functional layer material is deposited on one side of the substrate tape 1, called the bottom side 6. The functional layer material may be deposited by any suitable process, in particular having a sputtering nature (origin), e.g. magnetron or diode sputtering, ion beam sputtering or RF sputtering. In some cases a PLD (pulsed laser deposition) process may be employed. The functional layer 2 (or the functional layer material and the method employed for its deposition, respectively) yields a mechanically deforming effect on the substrate tape 1, causing some bending along the width direction WD, see status S2 ("negative deformation"), here with the side edges of the substrate tape 1 being bent downwards.

Subsequently, at deposition zone 5, buffer layer material is deposited on the other side of the substrate tape 1, called the front side 7. The buffer layer material is here deposited by an ABAD process (alternating beam assisted deposition), resulting in the textured buffer layer 3. The textured buffer layer 3 (i.e. the buffer layer material and the method for its deposition, respectively) produces a mechanically deforming effect for the substrate tape 1, too, which is opposed to the deforming effect of the functional layer 2. Accordingly, during deposition of the buffer layer material, the previous bending ("negative deformation") of the substrate tape 1 is reduced until the substrate tape 1 is flat again, and further deposited buffer layer material causes an increasing bending of the substrate tape 1 ("positive deformation"), here with the side edges of the substrate tape 1 being bent upwards, compare status S3.

The layer thicknesses, materials and regimes for their deposition are chosen here such that the absolute values of strain of the substrate tape 1 in state S2 and in state S3 are basically identical. The strain of the substrate tape 1 with respect to the width direction WD can be expresses as a maximum mutual inclination of surface areas of a side of the substrate tape 1, here at the opposing side edges of said side of the substrate tape 1, compare the angle between the tangents laid on the side edges in the cross-section. The absolute values of the maximum mutual inclinations MI2 and MI3 in state S2 and in state S3 are about the same, i.e. |MI2| = |MI3|, and during the manufacturing process, the absolute value of the momentary maximum mutual inclination will never be above |MI2|.

When directly depositing the textured buffer layer 3 on the substrate tape 1 without using any functional layer as in the state of the art, compare **Fig. 4**, then the strain will increase from a flat state S1 to a final state S2, resulting in a maximum mutual inclination MI2_{N}, wherein |MI2_{N}| is much larger than |MI2| of Fig. 1, assuming all other conditions (in particular substrate thickness and textured buffer layer thickness) are chosen identical. This means that in the state of the art, buffer layer material deposited later on will be deposited on a substrate tape 1 with a larger bending (or strain) as compared to the inventive method as shown in Fig. 1. In turn, the buffer layer material deposited by means of the invention will face a reduced deformation (strain) of the substrate tape 1 during the deposition, what can improve the texture quality of the textured buffer layer 3.

The inventive variants described in the following resemble the variant of Fig. 1, so above all the differences with respect to the variant of Fig. 1 are explained.

**Fig. 2** illustrates a second variant of a method for producing a HTS coated tape with respect to functional layer and textured buffer layer deposition.

In the variant of the inventive method of Fig. 2, the functional layer 2 is deposited in two steps. The initially flat substrate tape 1, compare state S1, passes through three deposition zones 4, 5, 6 here. At deposition zone 4, a first part (layer thickness part) of the functional layer 2 is deposited, causing some negative deformation, compare state S2. At deposition zone 5, the complete textured buffer layer 3 is deposited, removing the negative deformation and causing some positive deformation, see state S3. The hitherto procedure of Fig. 2 corresponds to the procedure of Fig. 1. Then a second part (layer thickness part) of the functional layer 3 is deposited, and the deforming effect of this second part of the functional layer 3 is enough to cancel out the strain of the substrate tape 1 of state S3, so that the final substrate tape 1 at state S4 is flat again. Then winding the HTS coated tape made from the substrate tape 1 coated with the textured buffer layer 3 and the functional layer 2 into a coil is facilitated, and good coil geometries allowing a high magnetic field strength may be manufactured.

**Fig. 3** illustrates a third variant of a method for producing a HTS coated layer with respect to functional layer and textured buffer layer deposition.

In this variant, the deposition zone 4 for depositing functional layer material and the deposition zone 5 for depositing buffer layer material act at identical positions (or position areas, respectively) on the substrate tape 1 with respect to the longitudinal direction LD, albeit on different sides 6, 7. The functional layer 2 is grown concurrently with the textured buffer layer 3; the layer thicknesses grow "in parallel" without offset with the progression (translation) of the substrate tape 1 through the deposition zones 4, 5. By this means, it is possible keep balanced the deforming effects of the functional layer 2 and the textured buffer layer 3 though the entire manufacturing time. The substrate tape 1, which is initially flat as can be seen in state S1, stays flat throughout the entire manufacturing time until it reaches its final state S2. In this way, the buffer layer material is always deposited on a substrate tape 1 with no strain (bending), allowing excellent texture quality for the textured buffer layer.

In the variant of Fig. 3, a sensor 9, here an optical sensor, is used to measure the strain (here bending with respect to the width direction) of the resulting substrate tape 1 after the concurrent deposition of functional layer 2 and the textured buffer layer 2. The measurements provided via the sensor 9 are analyzed by an electronic control device 8. Depending on the measured bending, the material outputs of the respective material sources of the deposition zones 4, 5 are readjusted by the control device 8, so as to obtain a flat final substrate tape 1 as shown in state S2 ("feedback control"). Typically, the control device 8 is programmed to the keep the strain of the substrate tape 1 below a defined limit value. Note that a corresponding feedback control may be applied in all inventive method variants illustrated above and below, for readjusting material deposition for the manufacturing process as a whole and/or for a particular step or steps of the manufacturing process, and also repeated measurements (and controls) at different stages of the manufacturing process can be applied.

In the variant illustrated in **Fig. 5**, the functional layer 2 is deposited in here five steps, wherein the substrate tape 1 passes through five deposition zones 4a-4e which are arranged subsequently with respect to the progression (translation) of the substrate tape 1 in longitudinal direction LD (note that the substrate tape 1 may be deflected along its translation in longitudinal direction LD). Note that the deposition zones 4a-4e can be realized separately, or can be realized as one deposition zone which is passed through five times to realize the five deposition steps. Analogously, the textured buffer layer 3 is deposited in five steps, wherein the substrate tape 1 passes five deposition zones 5a-5e which are arranged subsequently with respect to the progression (translation) of the substrate tape 1. Again, the deposition zones 4a-4e can be realized separately, or can be realized as one deposition zone which is passed through five times to realize the five deposition steps. Further note that the deposition zones 4a-4e and 5a-5e can be realized as one deposition zone which is passed through ten times, with the substrate tape being bent as needed so as to face the material source of the deposition zone with the required side 6, 7 of the substrate (compare Fig. 7a, 7b).

The functional layer material deposition steps and the buffer layer material deposition steps alternate. Starting from the flat substrate tape in state S1, here a first part (layer thickness part) of the functional layer is deposited at deposition zone 4a, causing a light strain (bending) in the substrate tape 1, see state S2. Then a first part (layer thickness part) of the textured buffer layer 3 is deposited, enough to remove the strain again, see the flat substrate tape 1 in state S3. Then a second part of the functional layer 2 is deposited at deposition zone 4b, causing again some strain again, see state S4, and then a second part of the textured buffer layer 3 is deposited at deposition zone 5b, removing that strain again, see state S5, and so on. The final substrate tape 1 (after deposition of the last part of the textured buffer layer 3) carrying the complete functional layer 2 and the complete textured buffer layer 3, is flat again, see state SF.

During the entire manufacturing process, the strain (deformation) of the substrate tape 1 never exceeds the strain (bending) of state S2 here, i.e. the state after deposition of only a small part (layer thickness part) of here one fifth of (here) the final functional layer 2.

Note that the process of Fig. 5 could alternatively start with a deposition of part of the textured buffer layer, and end with the deposition of a part of the functional layer, allowing for a similar limitation of the strain of the substrate tape 1 during the manufacturing process.

**Fig. 6a** in a perspective view and **Fig. 6b** in a side view show a setup for manufacturing a HTS coated tape (with respect to the deposition of the functional layer and the textured buffer layer) in a fifth variant, wherein the textured buffer layer is grown in (here) four steps, and the functional layer is grown in (here) three steps.

Substrate tape 1 is transported from a first reservoir 10 to a second reservoir 11. During this transport, the substrate tape 1 is lead over a winding rack 12, which here has four axes 13 for guide rollers 14. The substrate tape 1 is wound in a multitude of windings over the guide rollers 14.

In the variant shown, the substrate tape 1 passes through a deposition zone 5 for depositing the textured buffer layer on a front side 7 of the substrate tape 1, and through a deposition zone 4 for depositing the functional layer on a bottom side 6 of the substrate tape 1.

At the deposition zone 4, a multipath translation area 15 with three parallel windings of the substrate tape 1 is provided. Each location on the substrate tape 1, during transport of the substrate tape 1 from the reservoir 10 to the reservoir 11, will pass through the deposition area 4 three times, resulting in three deposition steps of functional layer material. At the deposition zone 5, a multipath translation area 16 with four parallel windings of the substrate tape 1 is provided. Each location on the substrate tape 1, during transport of the substrate tape 1 from the reservoir 10 to the reservoir 11, will pass through the deposition area 5 four times, resulting in four deposition steps.

Incoming substrate tape 1 passes alternatingly through the deposition zones 4 and 5 (here starting and ending with deposition zone 5), so the textured buffer layer and the functional layer are grown in alternating deposition steps offset in longitudinal direction along the substrate tape 1 (compare the similar situation in Fig. 5).

The setup shown in Fig. 6a, 6b is well suited for depositing different materials as functional layer material and textured buffer layer material. If desired, the same materials for the functional layer and the textured buffer layer may be used, though.

**Fig. 7a** in a perspective view and **Fig. 7b** in a side view show a setup for manufacturing a HTS coated tape (with respect to the deposition of the functional layer and the textured buffer layer) in a sixth variant, wherein the textured buffer layer is grown in (here) two steps, and the functional layer is grown in (here) two steps.

Again, substrate tape 1 is transported from a first reservoir 10 to a second reservoir 11. During this transport, the substrate tape 1 is lead over a winding rack 12, which here has four axes 13 for guide rollers 14a-14d. The substrate tape 1 is wound in a multitude of windings over the guide rollers 14a-14d.

In the variant shown, the substrate tape 1 passes through a deposition zone 17 for depositing both the textured buffer layer on a front side 7 of the substrate tape 1 and for depositing the functional layer on a bottom side 6 of the substrate tape 1. At the deposition zone 17, a multipath translation area 18 with four parallel windings of the substrate tape 1 is provided between the guide rollers 14a, 14b. Each location on the substrate tape 1, during transport of the substrate tape 1 from the reservoir 10 to the reservoir 11, will pass through the deposition zone 17 four times, resulting in four deposition steps. From winding to winding in the multipath translation area 18, the substrate tape 1 is twisted by 180°, here between the guide rollers 14c and 14d, compare the three twists 20. As a result, in the multipath translation area 18, the windings of the substrate tape 1 face a material source 19 of the deposition zone 17, located below the winding rack 12 here, alternatingly with the front side 7 and the bottom side 6. Accordingly, material deposition from the material source 19 will in the course of the transport of the substrate tape 1 from reservoir 10 to reservoir 11 alternatingly hit the front side 7 and the bottom side 6, resulting in respective parts (layer thickness parts) of the textured buffer layer and the functional layer on the substrate tape 1.

In this variant, the same material is used for the functional layer and the textured buffer layer.

Note that in both variants of Fig. 6a/b and Fig. 7a/b, the winding rack 12 may be passed multiple times by the substrate tape 1 if desired, by winding the substrate tape 1 back and forth between the reservoirs 10, 11, in order to increase the number of deposition steps as desired. In the variant of Fig. 7a/7b, where both the functional layer and the textured buffer layer are deposited by means of the same deposition zone 17, it may be useful to have functional layer deposition steps on the (with respect to the direction of the axes 13) outer windings of the multipath translation area 18, since texture quality tends to be worse here (but this is irrelevant for strain compensation), and textured buffer layer deposition steps on the inner windings of the multipath translation area 18 where the texture quality tends to be higher (so a high critical current may be achieved). Also note that the winding rack 12 may have some other geometry, such as comprising a large drum and a small drum between which the substrate tape 1 translates.

**Fig. 8** shows in a cross section perpendicular to the longitudinal direction a HTS coated tape (or HTS coated conductor) 34 in accordance with the invention, prepared using the inventive method.

On a substrate tape 1 typically made of a flexible metallic material such as stainless steel, on a front side 7, a textured buffer layer 3 is deposited, e.g. made of YSZ (yttrium stabilized zirconia). On top of the textured buffer layer 3, in the example shown, there is a cap buffer layer 31 and further a HTS (high temperature superconductor) layer 32, here made from ReBCO material (rare earth barium copper oxide, for example YBCO yttrium barium copper oxide). On top of the HTS layer 32, there is a metallic envelope (also called shunt layer or capping layer) 33 made of copper or a noble metal such as silver or gold.

On a bottom side 6 of the substrate tape 1, there is deposited a functional layer 2.

The layers deposited on the front side 7, and above all the textured buffer layer 3, exert a deforming effect on the substrate tape1. However, the functional layer 2 on the bottom side 6 also exerts a deforming effect on the substrate tape 1, opposing the deforming effect of the layers on the front side 7 of the substrate tape 1.

By depositing the functional layer 2 at least partially before and/or at least partially during the deposition of the textured buffer layer 3, a strain (in particular bending with respect to the width direction WD) of the substrate tape 1 may be limited. The invention is particularly suited for substrate tapes 1 with a high aspect ratio A=W/T, with W: width of the substrate tape and T: thickness of the substrate tape 1 (measured in normal direction, i.e. perpendicular to the width direction WD and the longitudinal direction), such as with A≥40, preferably A≥80, and most preferably A≥200.

### List of reference signs

- 1: substrate tape
- 2: functional layer
- 3: textured buffer layer
- 4: deposition zone (functional layer)
- 4a-4e: deposition zones (functional layer)
- 5: deposition zone (textured buffer layer)
- 5a-5e: deposition zones (functional layer)
- 6: bottom side
- 7: front side
- 8: control unit
- 9: sensor
- 10: reservoir
- 11: reservoir
- 12: winding rack
- 13: axis
- 14, 14a-14d: guide rollers
- 15: multipath translation area
- 16: multipath translation area
- 17: deposition zone (common for functional layer and textured buffer layer)
- 18: multipath translation area
- 19: material source
- 20: twist
- 31: cap buffer layer
- 32: HTS layer
- 33: metallic envelope
- 34: HTS coated tape
- LD: longitudinal direction
- MI2, MI3: maximum mutual inclination at states S2, S3
- MI2_{N}: maximum mutual inclination not using a functional layer at state
- S2:
- S1-S5, SF: states (substrate tape)
- T: thickness
- W: width
- WD: width direction

## Claims

1. A method for manufacturing an HTS coated tape (34),
the method comprising
- providing a substrate tape (1),
- depositing a textured buffer layer (3) onto a front side (7) of the substrate tape (1), and
- depositing an HTS layer (32) onto the front side (7) of the substrate tape (1),
**characterized by**
the method further comprising
- depositing a functional layer (2) onto a bottom side (6) of the substrate tape (1), wherein the functional layer (2) exerts a mechanically deforming effect on the substrate tape (1) opposite to a mechanically deforming effect on the substrate tape (1) exerted by the textured buffer layer (3) deposited on the front (7) side of the substrate tape (1),
and wherein the depositing of the functional layer (2) is at least partially done before and/or during the depositing of the textured buffer layer (3).

2. A method according to claim 1, **characterized in that** at least a part of the functional layer (2) is deposited onto the bottom side (6) of the substrate tape (1) before the textured buffer layer (3) is deposited onto the front side (7) of the substrate tape (1).

3. A method according to one of the preceding claims, **characterized in that** depositing the textured buffer layer (3) includes several buffer layer deposition steps and depositing the functional layer (2) includes several functional layer deposition steps, and that the buffer layer deposition steps and functional layer deposition steps are done alternatingly.

4. A method according to one of the preceding claims, **characterized in that** depositing the textured buffer layer (3) and the functional layer (2) includes concurrent deposition of buffer layer material on the front side (7) and deposition of functional layer material on the bottom side (6) at the same longitudinal position of the substrate tape (1).

5. A method according to one of the preceding claims, **characterized in that** the deposition of the textured buffer layer (1) is done with IBAD or ABAD or ISD.

6. A method according to one of the preceding claims, **characterized in that** the deposition of the functional layer (2) is done by sputtering.

7. A method according to one of the preceding claims, **characterized in that** the functional layer (2) comprises an oxide material, in particular YSZ and/or GdZrO and/or MgO.

8. A method according to one of the preceding claims, **characterized in that** the material of the textured buffer layer (3) and the material of the functional layer (2) are similar or identical.

9. A method according to one of the preceding claims, **characterized in that** the method is applied to a substrate tape (1) having a width (W) of at least 3 mm, preferably at least 8 mm, most preferably at least 12 mm, and/or a substrate tape (1) having an aspect ratio A=W/T, wherein A≥40, preferably A≥80, most preferably A≥200, with W: width of substrate tape (1) and T: thickness of substrate tape (1).

10. A method according to one of the preceding claims, **characterized in that** a degree of substrate tape strain, in particular a substrate tape curvature with respect to a width direction (WD), is repeatedly or continuously monitored during manufacturing of the HTS coated tape (34), and used to feedback-control the deposition of the textured buffer layer (3) and/or the deposition of the functional layer (2).

11. A method according to one of the preceding claims, **characterized in that** the manufacturing of the HTS coated tape (34) is done such that a substrate tape curvature with respect to a width direction is limited such that a maximum mutual inclination (MI2, MI3) of surface areas does not exceed 4°, preferably 2°, at any time during deposition of the textured buffer layer.

12. A method according to one of the preceding claims, **characterized in that** during deposition of the textured buffer layer (3) and deposition of the functional layer (2), the substrate tape (1) is translated between two reservoirs (10, 11) at least once, and preferably translated forth and back several times,
and that upon being translated between the two reservoirs (10, 11), the substrate tape (1) passes through at least one deposition zone (4; 4a-4e; 5; 5a-5e; 17) for depositing buffer layer material and/or functional layer material on the substrate tape (1).

13. A method according to claim 12, **characterized in that** the translation between the two reservoirs (10, 11) is done using a multipath translation area (15, 16; 18) with a multitude of windings of the substrate tape (1), wherein the substrate tape (1) is twisted at least once by a half turn within the multipath translation area (15, 16; 18).

14. A method according to one of the preceding claims, **characterized in that** the deposition of the layers on the front side (7) and on the bottom side (6) of the substrate tape (1), in particular the deposition of the textured buffer layer (3) and the deposition of the functional layer (2), are done such that their deforming effects are in total cancelled out, so the resulting HTS coated tape (34) is without strain.

15. A HTS coated tape (34), manufactured according to a method according to one of the claims 1 through 14.
